# EUROPEAN PATENT APPLICATION

(11) **EP 2 224 491 A2**
(43) Date of publication of application: **01.09.2010**
(21) Application number: 10001447.1
(22) Date of filing: 12.02.2010
(51) Int. Cl.: H01L 31/0224

(54) **Solar cell and method of fabricating the same**

(30) Priority: 27.02.2009 KR 20090016955
(71) Applicant: SAMSUNG ELECTRONICS CO., LTD., Yeongtong-gu Suwon-city Gyeonggi-do 442-742 (KR)
(72) Inventor: Kim, Byoung-Dong, Chungcheongnam-do (KR); Jun, Gug-Il, Gyeonggi-do (KR); Lee, Kang-Hee, Hwaseong-si Gyeonggi-do (KR); Lee, Woo-Su, Yongin-si Gyeonggi-do (KR); Lee, Byung-Joo, Seoul (KR)
(74) Representative: Weitzel, Wolfgang

(57) **Abstract**

Provided are a solar cell and a method of fabricating the same. The solar cell includes: a substrate; a rear electrode layer which is formed on the substrate and includes molybdenum (Mo); a protective layer which is formed on the rear electrode layer and includes silicon (Si); a light-absorbing layer which is formed on the protective layer and includes selenium (Se) and at least one of copper (Cu), gallium (Ga), and indium (In); and a transparent electrode layer formed on the light-absorbing layer.

## Description

### CROSS REFERENCE TO RELATED APPLICATION

This application claims priority from and the benefit of Korean Patent Application No. 10-2009-0016955, filed on February 27, 2009, which is hereby incorporated by reference for all purposes as if fully set forth herein.

### BACKGROUND OF THE INVENTION

FIELD OF THE INVENTION

Exemplary embodiments of the present invention relate to a solar cell and a method of fabricating the same, and more particularly, to a solar cell with improved efficiency.

DISCUSSION OF THE BACKGROUND

A solar cell or a photovoltaic cell converts solar energy directly into electricity and is a key element in solar power generation. Generally, a solar cell is formed of a p-n junction of semiconductors. When sunlight having energy greater than band gap energy (Eg) of a semiconductor is incident on a solar cell, electron-hole pairs are created. Here, an electric field generated at the p-n junction causes electrons and holes to move to an n-type layer and a p-type layer, respectively, thereby generating an electromotive force at both ends of the p-n junction. In this state, if a load is connected to electrodes at both ends of the p-n junction, an electric current flows through the p-n junction.

Recently, greenhouse gas emissions and an unstable supply of fossil fuel have dramatically increased interest in solar cells that capture electrical energy from unlimited solar energy. However, low photoelectric conversion efficiency of solar cells remains as a challenge that needs to be addressed.

In order to improve photoelectric conversion efficiency of conventional solar cells, attempts have been made to heat-treat a light-absorbing layer at a high temperature. However, such a heat-treatment process at a high temperature may cause a side reaction between materials of a rear electrode layer and the light-absorbing layer, thereby reducing adhesion between the rear electrode layer and a substrate. As a result, the conventional solar cells may become less stable.

In addition, the volume of a material created as a result of the side reaction may become three to four times greater than that of the rear electrode layer. This tends to increase resistance between the rear electrode layer and the light-absorbing layer, thereby reducing efficiency of the conventional solar cells.

To minimize the occurrence of the temperature-sensitive side reaction so as to solve the above problems, the light-absorbing layer was heat-treated at a lower temperature. In this case, however, characteristics of the light-absorbing layer were degraded, which, in turn, reduced overall efficiency of the conventional solar cells. Moreover, this method failed to prevent the occurrence of the side reaction since it was difficult to control the naturally occurring side reaction independently of the heat-treatment process.

### SUMMARY OF THE INVENTION

Exemplary embodiments of the present invention provide a solar cell which has improved photoelectric conversion efficiency and stability by preventing a side reaction between materials of a rear electrode layer and a light-absorbing layer.

Exemplary embodiments of the present invention also provide a method of fabricating a solar cell which has improved photoelectric conversion efficiency and stability.

Additional features of the invention will be set forth in the description which follows, and in part will be apparent from the description, or may be learned by practice of the invention.

An exemplary embodiment of the present invention discloses a solar cell including a substrate. A rear electrode layer is formed on the substrate and includes molybdenum (Mo). A protective layer is formed on the rear electrode layer and includes silicon (Si). A light-absorbing layer is formed on the protective layer and includes selenium (Se) and at least one of copper (Cu), gallium (Ga), and indium (In); and a transparent electrode layer is formed on the light-absorbing layer.

An exemplary embodiment of the present invention also discloses a method of fabricating a solar cell. The method includes: preparing a substrate; forming a rear electrode layer, which includes molybdenum, on the substrate; forming a protective layer, which includes silicon, on the rear electrode layer; forming a light-absorbing layer, which includes selenium and at least one of copper, gallium, and indium, on the protective layer. The method also includes forming a transparent electrode layer on the light-absorbing layer.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a cross-sectional view of a solar cell according to a first exemplary embodiment of the present invention.

FIG. 2 is a cross-sectional view of a solar cell according to a first modified embodiment of the first exemplary embodiment of the present invention.

FIG. 3 is a band gap energy diagram of the solar cell of FIG. 2.

FIG. 4 is a cross-sectional view of a solar cell according to a second modified embodiment of the first exemplary embodiment of the present invention.

FIG. 5, FIG. 6, FIG. 7, FIG. 8, FIG. 9, FIG. 10 and FIG. 11 are cross-sectional views sequentially showing processes included in a method of fabricating a solar cell according to a second exemplary embodiment of the present invention.

### DETAILED DESCRIPTION OF THE ILLUSTRATED EMBODIMENTS

Advantages and features of the present invention and methods of accomplishing the same may be understood more readily by reference to the following detailed description of exemplary embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims. In the drawings, sizes and relative sizes of layers and regions may be exaggerated for clarity.

It will be understood that when an element or layer is referred to as being "on" or "connected to" another element or layer, it can be directly on or directly connected to the other element or layer or intervening elements or layers may be present. In contrast, when an element or layer is referred to as being "directly on" or "directly connected to" another element or layer, there are no intervening elements or layers present. As used herein, the term "and/or" includes any and all combinations of one or more of the associated listed items.

Spatially relative terms, such as "below," "beneath," "lower," "above," "upper," and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures.

Embodiments of the invention are described herein with reference to plan and cross-section illustrations that are schematic illustrations of idealized embodiments of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

Hereinafter, a solar cell according to exemplary embodiments of the present invention will be described in detail with reference to the attached drawings.

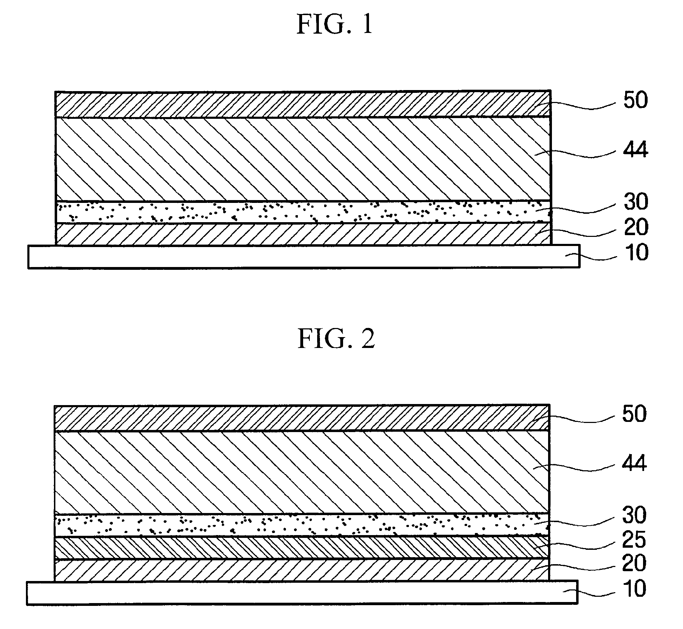

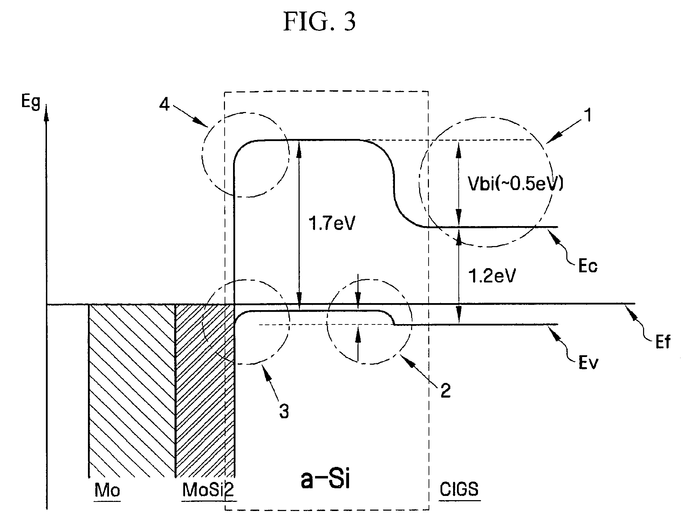

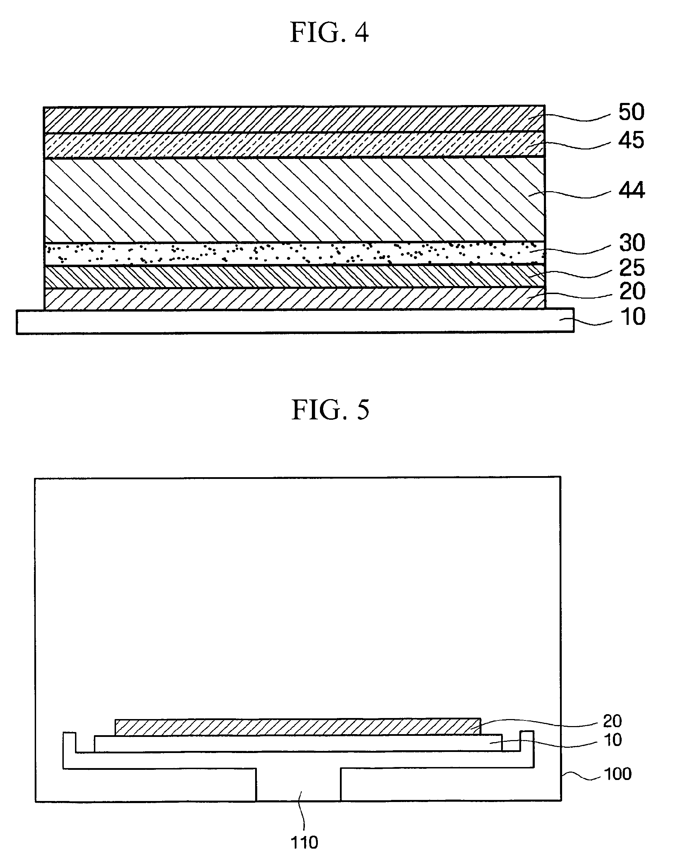

First, a solar cell according to a first exemplary embodiment of the present invention will be described in detail with reference to FIG. 1, FIG. 2, FIG. 3 and FIG. 4. FIG. 1 is a cross-sectional view of the solar cell according to the first exemplary embodiment of the present invention. FIG. 2 is a cross-sectional view of a solar cell according to a first modified embodiment of the first exemplary embodiment of the present invention. FIG. 3 is a band gap energy diagram of the solar cell of FIG. 2. FIG. 4 is a cross-sectional view of a solar cell according to a second modified embodiment of the first exemplary embodiment of the present invention.

Referring to FIG. 1, the solar cell according to the first exemplary embodiment of the present invention may include a substrate 10, a rear electrode layer 20, a protective layer 30, a light-absorbing layer 44, and a transparent electrode layer 50.

The substrate 10 is a base of the solar cell and generally formed of insulating glass. In particular, the substrate 10 may be formed of soda-lime glass for the following reason. That is, while the solar cell is manufactured, sodium (Na) contained in soda-lime glass may diffuse to the light-absorbing layer 44 which includes a compound of copper (Cu), indium (In), gallium (Ga), and selenium (Se) (hereinafter, referred to as the 'CIGS'). The diffusion of Na to the light-absorbing layer 44 may increase a charge concentration of the light-absorbing layer 44 that is formed of CIGS, thereby improving photoelectric conversion efficiency of the solar cell. Thus, in order to improve photoelectric conversion efficiency, it is advantageous to form the substrate 10 of the solar cell according to the first exemplary embodiment by using soda-lime glass. The substrate 10 may also be formed of ceramic such as alumina, stainless steel, a flexible polymer, or the like.

The rear electrode layer 20 causes electric charges generated in the light-absorbing layer 44 of the solar cell to move, so that an electric current flows out of the solar cell. To perform this function, the rear electrode layer 20 should have high electrical conductivity and low resistivity.

Since the rear electrode layer 20 contacts the CIGS compound of the light-absorbing layer 44, an ohmic contact with low contact resistance should be formed between the CIGS compound (i.e., a p-type semiconductor) and the rear electrode layer 20. The rear electrode layer 20 should remain stable when a heat-treatment process, which accompanies the formation of the CIGS compound, is performed at a high temperature in an atmosphere of a reactive gas containing Se. In addition, the rear electrode layer 20 should have superior adhesive properties so that it is not exfoliated from the substrate 10 due to the difference between thermal expansion coefficients of the rear electrode layer 20 and the substrate 10.

A material that has the above properties is molybdenum (Mo). Thus, the rear electrode layer 20 of the solar cell according to the first exemplary embodiment of the present invention is formed of Mo.

The protective layer 30 is formed on the rear electrode layer 20. The protective layer 30 inhibits a side reaction that occurs between Se used to form the light-absorbing layer 44, which will be described later, and Mo used to form the rear electrode layer 20. That is, the protective layer 30 prevents the diffusion of Se to the rear electrode layer 20. In addition, the protective layer 30 forms an electric potential on its surface of contact with CIGS of the light-absorbing layer 44, thereby improving the efficiency of collecting electrons and holes generated in the light-absorbing layer 44.

The protective layer 30 may be formed of silicon (Si). Here, the Si of the protective layer 30 may be amorphous silicon or polycrystalline silicon.

The Si protective layer 30 may be doped with dopants such as boron (B) and aluminum (Al), which are group III elements. Accordingly, the protective layer 30 has p-type semiconductor characteristics. The main reason why the protective layer 30 is formed as the p-type semiconductor is as follows.

Since the light-absorbing layer 44 of the solar cell according to the first exemplary embodiment of the present invention is formed of the CIGS compound, it has the p-type semiconductor characteristics. In addition, the transparent electrode layer 50 or a second buffer layer 45 (see FIG. 4), which will be described later, has n-type semiconductor characteristics. Accordingly, the light-absorbing layer 44 and the transparent electrode layer 50 or the second buffer layer 45 (see FIG. 4) form a p-n junction. Thus, electrons and holes created when sunlight is absorbed in the light-absorbing layer 44 may move in respective directions. That is, electrons and holes created when the light-absorbing layer 44 absorbed sunlight move to the transparent electrode layer 50 and the rear electrode layer 20, respectively. Here, if the protective layer 30 interposed between the rear electrode layer 20 and the light-absorbing layer 44 is an n-type semiconductor, an n-p-n junction is formed. The n-p-n junction may make the electrons and the holes created by the sunlight absorbed in the light-absorbing layer 44 unable to move freely, thereby overall efficiency of the solar cell may be deteriorated. Hence, Si of the protective layer 30 may be formed of a p-type semiconductor to allow the solar cell according to the first exemplary embodiment to maintain the p-n junction and prevent the solar cell's efficiency from being degraded.

The Si of the protective layer 30 may also be formed of an intrinsic semiconductor. In this case, Si of the protective layer 30 can serve as a passage through which metallic holes move, and the solar cell according to the first exemplary embodiment can maintain the p-n junction.

A ratio of a thickness of the protective layer 30 to that of the light-absorbing layer 44 may be 0.005 to 0.2. For example, when the thickness of the light-absorbing layer 44 is 1 to 2 µm, the protective layer 30 may have a thickness of 10 to 200 nm. If the ratio of the thickness of the protective layer 30 to that of the light-absorbing layer 44 is less than 0.005, Se used to form the light-absorbing layer 44 can easily penetrate the protective layer 30. Thus, a side reaction between Mo of the rear electrode layer 20 and Se cannot be inhibited. The side reaction between Se and Mo may generate MoSe₂, which is not desirable for the solar cell's efficiency and stability. If the ratio of the thickness of the protective layer 30 to that of the light-absorbing layer 44 is greater than 0.2, the path through which holes created in the light-absorbing layer 44 move to the rear electrode layer 20 is increased, which is not desirable for the solar cell's efficiency.

The protective layer 30 has a band gap energy Eg of 1.2 to 1.8 eV. When the band gap energy Eg of the protective layer 30 is less than 1.2 eV, a contact between the protective layer 30 and the light-absorbing layer 44 may not form a potential, thereby reducing the efficiency of collecting electrons or holes. When the band gap energy Eg of the protective layer 30 is greater than 1.8 eV, it is difficult for holes to move to the rear electrode layer 20, thereby reducing the solar cell's efficiency.

The light-absorbing layer 44 is formed on the protective layer 30. The light-absorbing layer 44 is formed of a compound containing Se and at least one of Cu, Ga, and In. Accordingly, the light-absorbing layer 44 according to the first exemplary embodiment may be formed of any one of a quaternary compound containing Cu, In, Ga, and Se and a ternary compound containing Cu, Ga, and Se or Cu, In, and Se. The following descriptions will be made based on the light-absorbing layer 44 formed of a quaternary compound.

The light-absorbing layer 44 formed of a quaternary compound has a chemical formula of Cu(GaₓIn₁₋ₓ)Se₂. In the crystal lattice structure of the Cu(GaₓIn₁₋ₓ)Se₂ compound, part of the In atoms are replaced by Ga atoms.

CIGS is called a chalcopyrite-based compound and has p-type semiconductor characteristics. A CIGS compound semiconductor has direct transition band gap energy. In addition, the CIGS compound semiconductor has a light-absorption coefficient of 1x10⁵cm⁻¹, which is highest among semiconductors. Thus, a highly efficient solar cell can be manufactured using a CIGS thin film with a thickness of only several µm. Since CIGS is chemically very stable, its long-term electro-optical stability is excellent.

The transparent electrode layer 50 is formed on the light-absorbing layer 44. The transparent electrode layer 50 is formed of a highly light-transmissive material such that sunlight can pass through the transparent electrode layer 50 to reach the light-absorbing layer 44. In order to function as an electrode layer, the transparent electrode layer 50 is also formed of a conductive material with low resistance. Examples of the material of the transparent electrode 50 include zinc oxide (ZnO) and indium tin oxide (ITO). ZnO is a conductive material and has a band gap energy of 3.3 eV and a high light transmittance of approximately 80 % or above. Moreover, ZnO has n-type semiconductor characteristics. Thus, the light-absorbing layer 44 and the transparent electrode layer 50 form the p-n junction.

To increase electrical conductivity of ZnO or ITO, B or Al is doped into ZnO. Since ZnO doped with B or Al has a resistance value of 10⁻⁴ Ω*cm or less, it can be used as an electrode. In particular, ZnO doped with B increases light transmittance in a near infrared region, thereby increasing short-circuit current of the solar cell.

Although not shown in the drawing, a reflection-preventing film may additionally be formed on the transparent electrode layer 50. The reflection-preventing film can reduce the reflection loss of sunlight incident on the solar cell, thereby improving the efficiency of the solar cell. The reflection-preventing film may be formed of MgF_{2.}

Hereinafter, referring to FIG. 2, a solar cell according to a first modified embodiment of the first exemplary embodiment of the present invention will be described in detail. For simplicity, elements substantially identical to those illustrated in the drawings for the first exemplary embodiment are indicated by like reference numerals, and thus their further description will be omitted. The structure of the solar cell according to the first modified embodiment is basically identical to that of the solar cell according to the first exemplary embodiment except for the following. That is, referring to FIG. 2, a first buffer layer 25 is formed between a protective layer 30 and a rear electrode layer 20 of the solar cell according to the first modified embodiment.

The first buffer layer 25 is formed between the protective layer 30 and the rear electrode layer 20 to form an ohmic contact between the protective layer 30 and the rear electrode layer 20. Accordingly, holes created in a light-absorbing layer 44 can move to the rear electrode layer 20 via protective layer 30 without any loss. As a result, a drop in an open circuit voltage Voc of the solar cell can be prevented, which, in turn, prevents the efficiency of the solar cell from being reduced.

Furthermore, the first buffer layer 25 increases adhesion between the protective layer 30 and the rear electrode layer 20. The increased adhesion prevents the protective layer 30 and the rear electrode layer 20 from being separated or peeled off of each other. That is, the solar cell becomes more stable.

Hereinafter, the band gap energy Eg of the solar cell according to the first exemplary embodiment of the present invention or the first modified embodiment thereof will be described with reference to FIG. 3.

Referring to FIG. 3, Ev represents an energy band in a valence band, and Ec represents an energy band in a conduction band. The band gap energy Eg is an energy gap between the energy band Ec in the conduction band and the energy band Ev in the valence band.

Generally, when the band gap energy Eg near the rear electrode layer 20 is high, recombination of electrons and holes in the light-absorbing layer 44 is prevented, thereby enhancing the solar cell's efficiency. In addition, when the band gap energy Eg near the rear electrode layer 20 is high, the open-circuit voltage Voc of the solar cell is increased, thereby enhancing the solar cell's efficiency.

The open-circuit voltage Voc is an electric potential difference between both terminals of a solar cell when light is incident on the solar cell in an infinite impedance state. The open-circuit voltage Voc is the maximum voltage that can be obtained from the solar cell. When the current of an open circuit is significantly smaller than that of a short circuit, the open-circuit voltage Voc is generally proportional to the intensity of incident light. If a p-n junction is formed properly, a semiconductor having a wider forbidden band has a greater open-circuit voltage Voc. In addition, when the band gap energy Eg increases, the open-circuit voltage Voc is increased owing to a reduction of the current in the open state.

Therefore, an increase in the band gap energy Eg at an interface between the light-absorbing layer 44 and the rear electrode layer 20 prevents recombination of holes and electrodes and increases the open-circuit voltage Voc, thereby enhancing overall efficiency of the solar cell.

In the solar cell according to the first exemplary embodiment of the present invention or the first modified embodiment thereof, the protective layer 30 or the first buffer layer 25 and the protective layer 30 are disposed between the rear electrode layer 20 and the light-absorbing layer 44. The effect of the protective layer 30 and the first buffer layer 25 on the band gap energy Eg of the solar cell will now be described.

Referring to a region indicated by reference numeral 1 in FIG. 3, CIGS of the light-absorbing layer 44 has a band gap energy of approximately 1 to 1.7 eV, depending on the concentration of Ga. CIGS exhibits its highest efficiency when a ratio of concentration of Ga to the sum of concentrations of Ga and In is approximately 20 to 30 %. Here, when the Ga concentration exhibits such a ratio to the sum of Ga and In concentrations, the band gap energy Eg of CIGS is approximately 1.2 eV.

Meanwhile, the protective layer 30 is formed of Si, and the band gap energy of Si is 1.7 eV. Accordingly, a potential Vbi of 0.5 eV, which is equivalent to the difference between the band gap energy Eg of the protective layer 30 and that of the light-absorbing layer 44, is formed at an interface between the protective layer 30 and the light-absorbing layer 44. The protective layer 30 having a greater band gap energy Eg than the light-absorbing layer 44 exhibits negative characteristics for the light-absorbing layer 44, and the light-absorbing layer 44 exhibits positive characteristics for the protective layer 30. Thus, electrons excited by absorption of sunlight can easily drift from the protective layer 30 toward the transparent electrode layer 50 due to the potential (0.5 eV) formed between the protective layer 30 and the light-absorbing layer 44 and the above-described characteristics of the protective layer 30 and the light-absorbing layer 44.

According to the first exemplary embodiment or the first modified embodiment, an internal electric field can be formed by forming the protective layer 30 and the first buffer layer 25 between the light-absorbing layer 44 and the rear electrode layer 20. In addition, the internal electric field causes electrons created in the light-absorbing layer 44 to be effectively collected in an electrode. That is, an enhanced back surface field (BSF) effect can be achieved, thereby improving overall efficiency of the solar cell.

Referring to a region indicated by reference numeral 2 in FIG. 3, the potential (of 0.5 eV) formed at the interface between the protective layer 30 and the light-absorbing layer 44 and the characteristics of the protective layer 30 and the light-absorbing layer 44 cause holes created in the light-absorbing layer 44 to drift toward the rear electrode layer 20. Therefore, according to the first exemplary embodiment or the first modified embodiment, holes can be effectively collected in the rear electrode layer 20, thereby improving overall efficiency of the solar cell.

Referring to a region indicated by reference numeral 3 in FIG. 3, a heat-treatment process at a high temperature is required to form CIGS. During the heat-treatment process, Mo of the rear electrode layer 20 reacts with Si of the protective layer 30 to form MoSi₂. That is, the first buffer layer 25 is formed.

As described above, MoSi₂ increases adhesion between the protective layer 30 and the rear electrode layer 20 and forms an ohmic contact between the protective layer 30 and the rear electrode layer 20. As a result, stability and efficiency of the solar cell can be improved.

Referring to a region indicated by reference numeral 4 in FIG. 3, a conduction band barrier is formed at an interface between Mo of the rear electrode layer 20 or MoSi₂ of the first buffer layer 25 and Si of the protective layer 30. Accordingly, electrons flowing from Mo of the rear electrode layer 20 or MoSi₂ of the first buffer layer 25 are prevented from recombining with holes, which are created in the light-absorbing layer 44 and drift toward the rear electrode layer 20. Since recombination of electrons and holes, which is a major cause of a reduction in efficiency of the solar cell, is prevented, overall efficiency of the solar cell can be improved.

The above descriptions may also be applied to band gap energy of a solar cell according to a second modified embodiment which will now be described.

Hereinafter, the solar cell according to the second modified embodiment of the first exemplary embodiment of the present invention will be described in detail. For simplicity, elements substantially identical to those illustrated in the drawings for the first exemplary embodiment are indicated by like reference numerals, and thus their further description will be omitted. The structure of the solar cell according to the second modified embodiment is basically identical to that of the solar cell according to the first exemplary embodiment except for the following. That is, referring to FIG. 4, the second buffer layer 45 is formed between a light-absorbing layer 44 and a transparent electrode layer 50 of the solar cell according to the second modified embodiment.

As described above, in the solar cell having CIGS as the light-absorbing layer 44, a p-n junction is formed between CIGS, which is an n-type semiconductor, and ZnO of the transparent electrode layer 50. However, since there is a large difference in lattice constant and band gap energy between the above two materials, it is difficult to form a favorable p-n junction. To form a favorable p-n junction, the second buffer layer 45 needs to be formed of a material having a band gap energy greater than the band gap energy of CIGS of the light-absorbing layer 44 and lower than the band gap energy of ZnO of the transparent electrode layer 50.

Examples of the material of the second buffer layer 45 include CdS and ZnS which are n-type semiconductors. To obtain a low resistance value, these materials (CdS and ZnS) may be doped with In, Ga, Al, and the like.

Hereinafter, a method of fabricating a solar cell according to a second exemplary embodiment of the present invention will be descried in detail with reference to FIG. 5, FIG. 6, FIG. 7, FIG. 8, FIG. 9, FIG. 10 and FIG. 11. FIGS. 5 through 11 are cross-sectional views sequentially showing processes included in the method of fabricating a solar cell according to the second exemplary embodiment of the present invention.

Referring to FIG. 5, a substrate 10, which is a base of a solar cell, is prepared on a support 110 in a chamber 100 for forming a solar cell. The substrate 10 may be formed of any one of glass, ceramic, stainless steel, and a flexible polymer. If glass is used to form the substrate 10, soda-lime glass is desirable as described above.

Next, a rear electrode layer 20 is formed on the substrate 10. As described above, Mo that satisfies all requirements for the rear electrode layer 20 is used to form the rear electrode layer 20. The rear electrode layer 20 may be formed by a direct current (DC) sputtering method which targets Mo. Alternatively, the rear electrode layer 20 may be formed by a chemical vapor deposition (CVD) method.

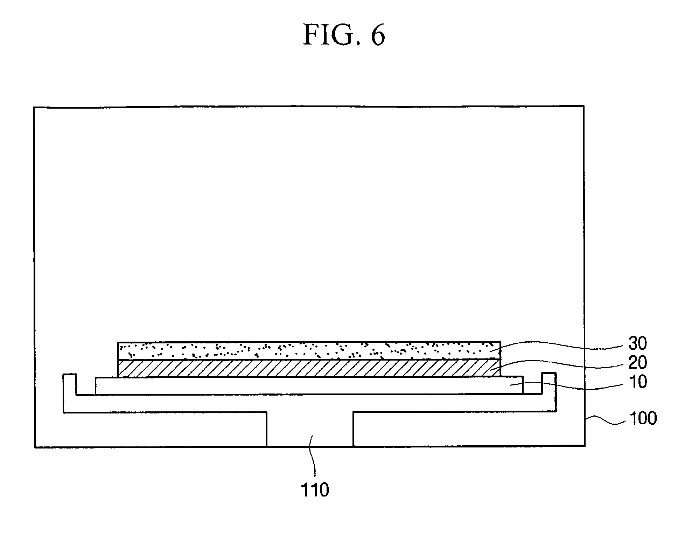

Referring to FIG. 6, a protective layer 30 is formed on the rear electrode layer 20. The protective layer 30 is formed of Si. Here, the protective layer 30 may be formed of hydrogenated amorphous silicon. The amorphous silicon is formed using a mixture of a Si-containing gas and hydrogen, such as SiH₄, SiH₂Cl₂, or SiH₂F₂. Alternatively, polycrystalline silicon (polysilicon) may be stacked on the rear electrode layer 20 by the CVD method to form the protective layer 30.

After the protective layer 30 is formed of amorphous silicon or polycrystalline silicon, an ion-doping process may be performed to form a p-type semiconductor. The ion-doping process is performed using B or Al, which are group III elements, as dopants to form a p-type semiconductor. Further, the amorphous silicon or polycrystalline silicon may be formed by intrinsic. When the amorphous silicon or polycrystalline silicon is formed by intrinsic, the ion-doping process may not be performed.

When the concentration of dopants in the protective layer 30 increases, a slope of a potential formed at an interface between the protective layer 30 and a light-absorbing layer 44 may be increased.

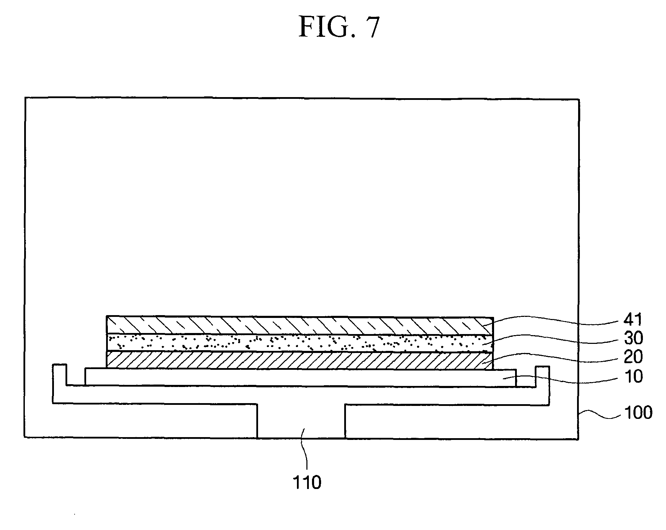

Referring to FIG. 7, a first precursor layer 41 containing any one of Cu, Ga, and In is formed on the protective layer 30.

The first precursor layer 41 may be formed by a sputtering method which uses Cu, Ga, or In as a target material. Alternatively, an alloy of Cu and Ga or an alloy of Cu and In may be used as a target material. Accordingly, the first precursor layer 41 contains Cu and Ga or Cu and In.

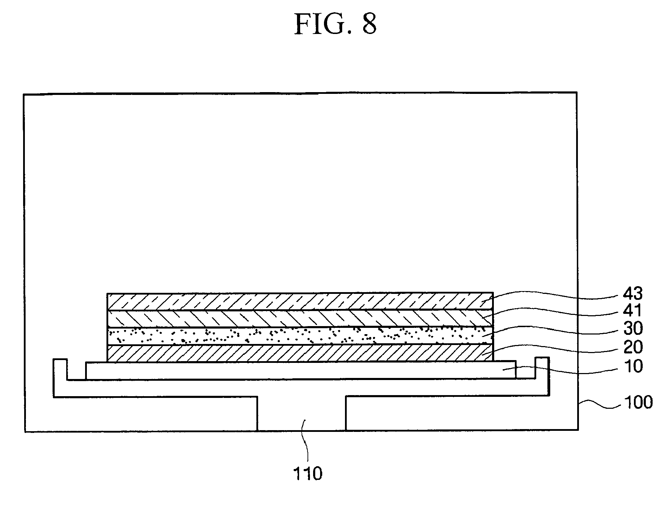

Referring to FIG. 8, a second precursor layer 43 containing any one of Ga and In is formed on the first precursor layer 41. When the first precursor layer 41 contains Cu and Ga, the second precursor layer 43 may contain In. When the first precursor layer 41 contains Cu and In, the second precursor layer 43 may contain Ga. The second precursor layer 43 may be formed by a sputtering method which uses Ga or In as a target material.

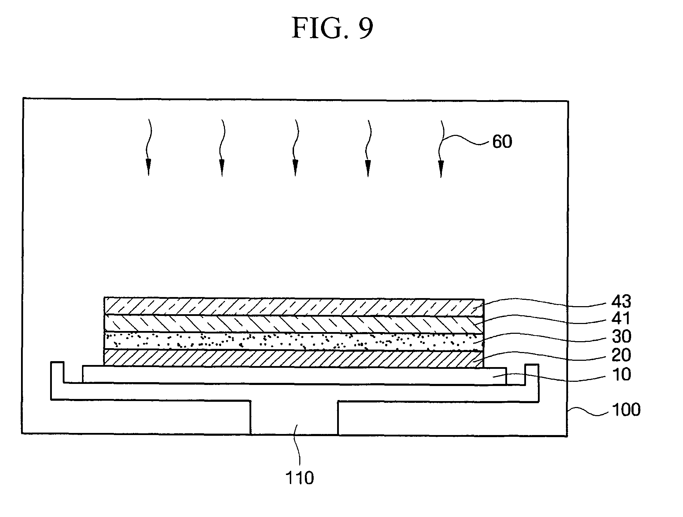

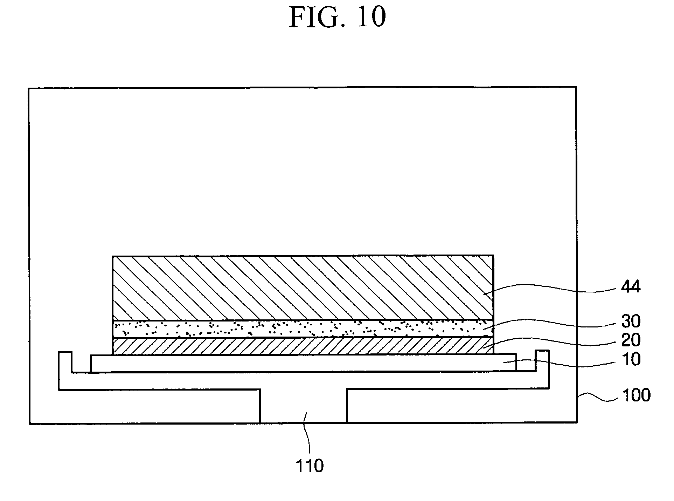

Referring to FIG. 9 and FIG. 10, the first precursor layer 41 and the second precursor layer 43 are heat-treated using a reactive gas 60 that contains Se. For the heat-treatment process, the chamber 100 is put in a vacuum state.

Next, the reactive gas 60 containing Se is introduced into the chamber 100. The reactive gas 60 containing Se may be H₂Se or Se steam. When the reactive gas 60 is introduced into the chamber 100, an inert gas may also be introduced into the chamber 100 to control pressure within the chamber 100. The inert gas may be argon (Ar) or nitrogen (N₂). Here, when the inert gas has a flow rate of 100 %, a flow rate of the reactive gas 60 introduced into the chamber 100 may be 5 to 20 %.

In view of charge mobility in CIGS that is formed, overall efficiency of the solar cell, and thermal deformation of the substrate 10, the heat-treatment process is carried out in the chamber 100 maintained at a temperature in a range from 400 to 600 °C. In addition, the heat-treatment process is performed for 10 to 60 minutes in view of a latent period required to form the CIGS compound and a performance reduction resulting from the non-uniform distribution of Ga in the crystal lattice of the CIGS compound.

As a result of the heat-treatment process, the first precursor layer 41, the second precursor layer 43, and Se are combined with each other to form the CIGS compound having a clialcopyrite-based crystal structure.

Se introduced into the chamber 100 during the heat-treatment process diffuses to the first precursor layer 41 and the second precursor layer 43, but not to the rear electrode layer 20 due to the protective layer 30. Accordingly, Mo of the rear electrode layer 20 does not contact and thus does not react with Se. As a result, MoSe₂ is not formed.

Generally, MoSe₂ created by the reaction of Se with Mo during the formation of CIGS reduces adhesion between a substrate and a solar cell, thereby causing the substrate and the solar cell to be peeled off each other. This not only reduces the stability of the solar cell but also increases resistance between CIGS and a rear electrode layer, thereby reducing a fill factor. Therefore, when CIGS is formed, the formation of MoSe₂ must be prevented.

However, MoSe₂ is formed naturally when the heat-treatment process is performed at a high temperature to form CIGS. Thus, it is very difficult to prevent the formation of MoSe₂ independently of the formation of CIGS. In particular, to enhance the thin-film quality of CIGS, the heat-treatment process should be performed at a high temperature of 550 °C or above. However, at a temperature of 550 °C or above, Se reacts more rapidly with Mo than Cu, In and Ga. Thus, MoSe₂ is formed more rapidly. For this reason, the heat-treatment process is performed at a temperature, at which a compromise can be reached between the quality of CIGS and the generation of MoSe₂, to minimize the generation of MoSe₂ and form CIGS as a compound having superior crystallinity.

According to the second exemplary embodiment of the present invention, since the protective layer 30 is formed on the rear electrode layer 20, Se can be prevented from diffusing to the rear electrode layer 20. Accordingly, Se is prevented from contacting Mo, which, in turn, prevents the formation of MoSe₂ by the reaction of Se with Mo. Therefore, according to the second exemplary embodiment, the heat-treatment process for forming CIGS can be performed at a temperature of 550 °C or above. Consequently, CIGS having superior crystallinity can be formed.

When the protective layer 30 is formed of amorphous silicon, the amorphous silicon of the protective layer 30 may be crystallized into polycrystalline silicon during the heat-treatment process for forming CIGS. Here, Cu contained in the first precursor layer 41 may diffuse to the protective layer 30, and Cu diffused to the protective layer 30 may function as a seed for crystallizing amorphous silicon into polycrystalline silicon. That is, Cu diffuses to the protective layer 30 formed of amorphous silicon, and the amorphous silicon may be crystallized by a metal induced crystallization (MIC) method which uses Cu as a seed.

In the heat-treatment process for forming CIGS, Ga or In, which is a group III element contained in the first precursor layer 41 or the second precursor layer 43, may diffuse to the protective layer 30. Accordingly, in the heat-treatment process, the effect of doping Si of the protective layer 30 with p-type dopants can be obtained.

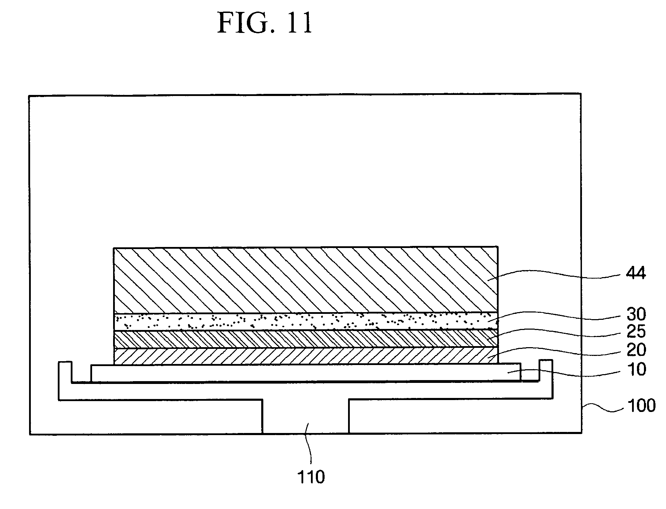

Referring to FIG. 11, during the heat-treatment process for forming CIGS, Si of the protective layer 30 reacts with Mo of the rear electrode layer 20 to form a first buffer layer 25. Under the above heat-treatment conditions, Mo and Si are naturally combined with each other to form MoSi₂.

Next, a transparent electrode layer 50 is formed on the light-absorbing layer 44 of FIG. 10 or FIG. 11.

The transparent electrode layer 50 may be formed of ZnO. Accordingly, the transparent electrode layer 50 may be formed by any one of a radio frequency (RF) sputtering method that uses ZnO as a target material, a reactive sputtering method that uses zinc (Zn) as a target material, and a metal organic CVD (MOCVD) method. Consequently, the solar cell of FIG. 1 or FIG. 2 is completed.

Before the transparent electrode layer 50 is formed, the second buffer layer 45 (see FIG. 4) may be formed on the light-absorbing layer of FIG. 10 or FIG. 11.

The second buffer layer 45 is generally formed of CdS by a chemical bath deposition (CBD) method. The CBD method using CdS is as follows. Appropriate amounts of Cd²⁺ and S²⁻ ions are created in a solution. Then, the temperature of the solution is controlled to precipitate the ions as CdS when a value obtained by multiplying concentrations of the ions is greater than a value obtained by multiplying solubilities of the solution. In this way, the second buffer layer 45 is formed to a thickness of approximately 50 nm. Consequently, the solar cell of FIG. 4 is completed.

Additionally, a reflection-preventing film (not shown) may be formed on the transparent electrode layer 50 of FIG. 1, FIG. 2 or FIG. 4. The reflection-preventing film may be formed of MgF₂ by an electron beam vaporization method.

White the present invention has been particularly shown and described with reference to exemplary embodiments thereof, the exemplary embodiments should be considered in a descriptive sense only and not for purposes of limitation. It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A solar cell, comprising:
a substrate;
a rear electrode layer disposed on the substrate and comprising molybdenum (Mo);
a protective layer disposed on the rear electrode layer and comprising silicon (Si);
a light-absorbing layer disposed on the protective layer, the light-absorbing layer comprising selenium (Se) and at least one of copper (Cu), gallium (Ga), and indium (In); and
a transparent electrode layer disposed on the light-absorbing layer.

2. The solar cell of claim 1, wherein the silicon comprises one of amorphous silicon and polycrystalline silicon.

3. The solar cell of claim 2, wherein the silicon is intrinsic or doped with a p-type dopant.

4. The solar cell of claim 1, wherein a ratio of a thickness of the protective layer to a thickness of the light-absorbing layer is in a range from 0.005 to 0.2.

5. The solar cell of claim 4, wherein the thickness of the light-absorbing layer is 10 to 200 nm.

6. The solar cell of claim 1, wherein the protective layer has a band gap energy of 1.2 to 1.8 eV.

7. The solar cell of claim 1, further comprising a first buffer layer disposed between the protective layer and the rear electrode layer.

8. The solar cell of claim 7, wherein the first buffer layer comprises MoSi₂.

9. The solar cell of claim 1, further comprising a second buffer layer disposed between the light-absorbing layer and the transparent electrode layer.
